(19) Europäisches Patentamt
European Patent Office
Office européen des brevets

(11) **EP 3 492 891 A1**

(12) **DEMANDE DE BREVET EUROPEEN**

(43) Date de publication:
**05.06.2019 Bulletin 2019/23**

(21) Numéro de dépôt: **18209894.7**

(22) Date de dépôt: **03.12.2018**

(51) Int Cl.:
*G01J 5/04* (2006.01)          *G01J 5/02* (2006.01)
*G01J 5/06* (2006.01)          *G01J 5/34* (2006.01)
*G01J 5/00* (2006.01)          *H01L 37/02* (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **04.12.2017 FR 1761600**

(71) Demandeur: **Commissariat à l'énergie atomique et aux énergies alternatives**
**75015 Paris (FR)**

(72) Inventeurs:
• **BENWADIH, Mohammed**
  **94500 CHAMPIGNY SUR MARNE (FR)**
• **REVENANT-BRIZARD, Christine**
  **38000 GRENOBLE (FR)**

(74) Mandataire: **Brevalex**
  **95, rue d'Amsterdam**
  **75378 Paris Cedex 8 (FR)**

(54) **CAPTEUR DE MOTIF THERMIQUE A CAPACITE PYROELECTRIQUE COMPRENANT UNE MATRICE SOL-GEL ET DES PARTICULES D'OXYDE METALLIQUE**

(57) Capteur de motif thermique comportant plusieurs pixels (102) disposés sur un substrat (104), chaque pixel (102) comprenant une capacité pyroélectrique, la capacité pyroélectrique comprenant un matériau pyroélectrique (200) disposé entre deux électrodes électriquement conductrices (108, 110),
le matériau pyroélectrique (200) comprenant une matrice sol-gel (210) dans laquelle sont dispersées des premières particules (220) en un premier matériau et des deuxièmes particules (230) en un deuxième matériau,
le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium, de vanadium et/ou de manganèse.

FIG.3

EP 3 492 891 A1

**Description**

**DOMAINE TECHNIQUE ET ART ANTÉRIEUR**

L'invention se rapporte à un capteur de motifs thermiques, exploitant les propriétés de pyroélectricité d'un matériau, et formant avantageusement un capteur d'empreinte digitale.

La détection d'empreinte digitale peut être réalisée par des capteurs dits « passifs » exploitant une différence de températures entre celle du doigt et celle du capteur, comme décrit dans les documents US 4 394 773, US 4 429 413 et US 6 289 114. Au niveau des crêtes de l'empreinte, le doigt est en contact physique direct avec le capteur. Un transfert thermique entre la peau et la surface de contact du capteur s'effectue par conduction, ce qui conduit à une première variation temporelle de température. Au niveau des vallées de l'empreinte, le doigt n'est pas en contact physique direct avec le capteur, le transfert thermique s'effectue donc à travers l'air qui est plutôt un isolant thermique, ce qui conduit à une seconde variation temporelle de température, moins importante. La différence entre ces deux variations temporelles de température se traduit par une différence entre des signaux mesurés par les capacités pyroélectriques, selon qu'elles se trouvent sous une vallée ou sous une crête de l'empreinte. L'image de l'empreinte présente donc un contraste qui dépend de cette différence.

Cependant, ces capteurs ont pour inconvénient de réaliser une mesure qui dépend uniquement de la différence entre la température du doigt et la température du capteur. Ainsi, après quelques secondes à peine, la température du doigt et la température de la surface de contact du capteur s'homogénéisent, et il n'est plus possible d'obtenir un contraste satisfaisant.

Il peut également arriver que le niveau du signal obtenu soit nul lorsque le doigt et le capteur sont à la même température, ou encore que le contraste des images capturées varie, ce qui pose alors des problèmes lors du traitement ultérieur des images obtenues (par exemple, une inversion des températures entraîne une inversion de l'image obtenue).

Un autre type de capteur, de type actif, offre une solution à ce problème grâce à l'ajout d'éléments chauffants sous la surface de contact du capteur. Un tel capteur est décrit par exemple dans la demande de brevet EP 2 385 486 A1. Les éléments chauffants dissipent une certaine quantité de chaleur dans chaque pixel du capteur et l'échauffement des pixels est mesuré au bout d'un certain temps. La variation de température obtenue est donc importante au niveau des vallées de l'empreinte, où la chaleur est transférée au doigt à travers l'air, et plus faible au niveau des crêtes de l'empreinte, où la chaleur est transférée directement au doigt, par conduction. Cela conduit à une température finale plus faible dans le cas d'un pixel en présence d'une crête de l'empreinte, où la chaleur est absorbée par la peau, par rapport à un pixel en présence d'une vallée de l'empreinte. Cela permet d'améliorer et de conserver au cours du temps, le contraste d'une image acquise à l'aide dudit capteur.

Les éléments décrits ci-dessus pour la détection d'empreinte digitale s'appliquent également à la détection d'un motif thermique autre qu'une empreinte digitale, l'élément dont le motif thermique à détecter étant disposé sur le capteur lors de la mesure.

Un capteur de motifs thermiques comporte des moyens de détection thermique qui peuvent être des éléments pyroélectriques, des diodes, des thermistances ou tout autre élément sensible à la température permettant de convertir une variation de température en une variation de potentiel ou de courant électrique.

Plus particulièrement, un capteur de type pyroélectrique comporte une matrice de capacités pyroélectriques disposées sur un substrat, par exemple en verre. Chaque capacité pyroélectrique comporte une portion en matériau pyroélectrique, disposée entre une électrode inférieure et une électrode supérieure. Une électrode est portée à un potentiel constant, et forme une électrode de référence. L'autre électrode collecte des charges pyroélectriques, générées par le matériau pyroélectrique en réponse à une variation de température.

Le matériau pyroélectrique peut être par exemple un poly(fluorure de vinylidène-trifluoroéthylène), noté P(VDF-TrFE), un PVDF (polyfluorure de vinylidène), une céramique telle que du PZT (titano-zirconate de plomb, ou « Lead Zirconate Titanate » en anglais), de l'AlN, du $BaTiO_3$ ou encore du ZnO. D'autres matériaux pyroélectriques sont possibles, à savoir tous ceux qui produisent des charges électriques en fonction d'un paramètre pyroélectrique. L'électrode supérieure est recouverte d'une couche de protection sur laquelle l'élément dont le motif thermique est mesuré, par exemple un doigt, est destiné à être disposé lors de la mesure.

Dans le cas d'un capteur thermique actif, le capteur est également muni d'un élément chauffant généralement réalisé à partir de la même couche électriquement conductrice que celle servant à réaliser l'électrode supérieure. Cet élément chauffant est par exemple réalisé sous la forme d'un serpentin entourant partiellement les électrodes supérieures et permettant de chauffer latéralement les capacités pyroélectriques, au niveau des électrodes supérieures.

Chaque capacité pyroélectrique forme un transducteur qui traduit une variation temporelle de température en un signal électrique tel qu'une différence de potentiels électriques.

Lorsque la portion de matériau pyroélectrique est soumise à une variation de température $\Delta T$, cette variation de température $\Delta T$ provoque l'apparition d'un champ électrique supplémentaire au sein de la capacité pyroélectrique, générant des charges $\Delta Q$ entre les électrodes telles que :

$$\Delta Q = S.\gamma.\Delta T \qquad (1)$$

Le paramètre S correspond à la surface de la portion de matériau pyroélectrique se trouvant en regard de chacune des électrodes. Le paramètre γ correspond au coefficient pyroélectrique du matériau pyroélectrique de la portion. Par exemple, le coefficient pyroélectrique γ du PVDF est compris entre 20 et 35 $\mu$C/m$^2$/K pour une température variant de 20°C à 60°C.

Les propriétés du matériau pyroélectrique, ainsi que l'efficacité de la détection pyroélectrique, sont définies par la figure de mérite $F_v$ qui est, dans le cas d'une couche mince : $F_v = \gamma/\varepsilon_0\varepsilon_r$ avec :

γ le coefficient pyroélectrique,
$\varepsilon_r$ la permittivité diélectrique de la couche pyroélectrique,
$\varepsilon_0$ la permittivité diélectrique du vide.

Pour améliorer les propriétés pyroélectrique du capteur, et avoir le facteur de mérite le plus élevé possible, il est donc nécessaire d'augmenter le coefficient pyroélectrique du matériau pyroélectrique et/ou de diminuer sa permittivité diélectrique.

**EXPOSÉ DE L'INVENTION**

Un but de la présente invention est de proposer un capteur de motif thermique dont la structure soit compatible avec la réalisation d'un capteur de type passif ou actif, et dont les propriétés pyroélectriques soient améliorées par rapport à l'art antérieur.

Pour cela, la présente invention propose un capteur de motif thermique comportant plusieurs pixels disposés sur un substrat, chaque pixel comprenant une capacité pyroélectrique, la capacité pyroélectrique comprenant un matériau pyroélectrique disposé entre deux électrodes électriquement conductrices,
le matériau pyroélectrique comprenant une matrice sol-gel en oxyde métallique dans laquelle sont dispersées des premières particules en un premier matériau et des deuxièmes particules en un deuxième matériau.
le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium, de vanadium et/ou de manganèse.

L'invention se distingue fondamentalement de l'art antérieur par la nature du matériau pyroélectrique. Un tel matériau est particulièrement avantageux.

La matrice sol-gel en oxyde métallique présente une faible permittivité diélectrique εr. Elle a, également, un coefficient pyroélectrique supérieur à celui du PVDF classiquement utilisé dans les capacités pyroélectriques.

La présence et le choix des premières particules et des deuxièmes particules conduit à la création de moment dipolaire au sein de la matrice sol-gel, ce qui augmente le coefficient pyroélectriquement perpendiculairement à l'empilement électrodes/matériau pyroélectrique. On obtient une capacité ayant une grande conductivité thermique du matériau pyroélectrique perpendiculairement à l'empilement électrodes/matériau pyroélectrique et une bonne isolation thermique du matériau pyroélectrique parallèlement à l'empilement électrodes/matériau. La capacité pyroélectrique selon l'invention présente des propriétés pyroélectriques améliorées.

Avantageusement, la matrice sol-gel est en au moins un oxyde choisi parmi les oxydes d'aluminium, les oxydes de silicium, les oxydes de gallium et les oxydes de zirconium. De telles matrices présentent de faibles permittivité, notamment une matrice en silicium.

Avantageusement, le matériau pyroélectrique est choisi parmi les matériaux suivants :

- une matrice sol-gel en oxyde d'aluminium avec des premières particules en oxydes de strontium et deuxièmes particules en oxyde de zinc,
- une matrice sol-gel en oxyde de silicium avec des premières particules en oxyde de strontium et deuxièmes particules en oxyde de zinc,
- une matrice sol-gel en oxyde de silicium avec des premières particules en oxyde de strontium et deuxièmes particules en oxyde de vanadium,
- une matrice sol-gel en oxyde d'aluminium avec des premières particules en oxyde de strontium et deuxièmes particules en oxyde de vanadium,
- une matrice sol-gel est en oxyde de silicium, des premières particules en oxyde de plomb et des deuxièmes particules en oxyde de titane,
- une matrice sol-gel en oxyde d'aluminium, des premières particules en oxyde de strontium et des deuxièmes particules en oxyde de titane.

Avantageusement, la distance entre les premières particules est inférieure à 50 nm. Plus les particules sont nombreuses et rapprochées, plus la quantité de charges électriques dans le matériau pyroélectrique augmente.

Avantageusement, le matériau pyroélectrique comprend de 30% à 70% massique de matrice sol-gel, de 30% à 50% massique de premières particules, et de 10% à 20% massique de deuxièmes particules.

Encore plus avantageusement, le matériau pyroélectrique comprend 40% massique de matrice sol-gel, 40% massique de premières particules, et 20% massique de deuxièmes particules.

Avantageusement, le matériau pyroélectrique a une porosité surfacique supérieure à 15% de la surface totale du matériau pyroélectrique. Une telle porosité permet de diminuer à la fois la permittivité diélectrique et la conductivité thermique, dans un plan parallèle à l'empilement électrodes/matériau pyroélectrique.

Avantageusement, le matériau pyroélectrique a une épaisseur allant de 20 nm à 3 $\mu$m. De telles épaisseurs sont suffisantes pour les applications recherchées.

Avantageusement, l'une des électrodes électriquement conductrices de chaque pixel est reliée électriquement à un potentiel électrique fixe.

Avantageusement, le capteur comporte en outre au moins un élément chauffant isolé électriquement des électrodes électriquement conductrices et disposé en regard d'au moins une partie du matériau pyroélectrique tel que le matériau pyroélectrique soit disposé entre l'élément chauffant et le substrat.

Avantageusement, le capteur est un capteur d'empreinte digitale.

L'invention concerne également un procédé de préparation d'un matériau pyroélectrique tel que défini précédemment, comprenant les étapes successives suivantes :

a) fourniture d'un substrat,
b) dépôt, sur le substrat, d'une solution sol-gel comprenant des précurseurs polymériques de la matrice sol-gel, un solvant, des premières particules en un premier matériau et des deuxièmes particules en un deuxième matériau, et évaporation du solvant de manière à former un matériau pyroélectrique,

le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium et/ou de manganèse.

Les différents composants du matériau pyroélectrique vont se mélanger en solution. La démixtion commence dès l'étape de mise en solution. Cependant, les composants élémentaires sont, à ce stade, éloignés les uns des autres. C'est l'évaporation du solvant, lors du dépôt, dans un deuxième temps et, ensuite, l'étape de recuit qui vont significativement séparer et faire grossir les différents composants en oxydes élémentaires (démixtion), grâce à la différence de leur énergie de surface. Le matériau pyroélectrique obtenu présente un fort coefficient pyroélectrique et une faible permittivité.

La méthode de dépôt par voie sol-gel présente l'avantage d'être simple à mettre en oeuvre et peu coûteuse.

Avantageusement, après l'étape b), un traitement thermique à une température d'au moins 150°C, par exemple de 150°C à 250°C est réalisé sur le matériau pyroélectrique. De telles températures sont compatibles avec de nombreux substrats en polymère.

Lors du traitement thermique, le solvant s'évapore et/ou des espèces organiques issues des précurseurs de synthèse disparaissent, ce qui augmente la porosité du matériau pyroélectrique. Cette étape de traitement thermique améliore également la démixtion des composants du matériau pyroélectrique.

Avantageusement, la température du traitement thermique est d'au moins 400°C, par exemple de 400° à 500°C. De telles températures permettent d'obtenir une porosité surfacique importante (supérieure à 28%) et donc un matériau présentant une faible permittivité, de l'ordre de grandeur de la permittivité des matériaux amorphes.

Une étape de cristallisation soit par laser UV soit par recuit thermique a une température d'environ 650°C peut être réalisée pour rendre le matériau pyroélectrique cristallin.

Avantageusement, la solution sol-gel de l'étape b) est obtenue en réalisant les étapes suivantes :

a1) Préparation d'une solution comprenant des sels métalliques et un solvant, de préférence, un solvant organique, et mélange de la solution jusqu'à dissolution des sels métalliques dans le solvant, de manière à former des ions métalliques.
b1) Ajout d'un agent chélatant et, éventuellement, d'un agent complexant à la solution obtenue à l'étape a1), de manière à former des complexes métalliques, à partir des ions métalliques et de l'agent chélatant.
c1) Mélange et agitation de la solution, de préférence, à une température supérieure à 50°C, de manière à polymériser les complexes métalliques et à obtenir une solution sol-gel contenant les précurseurs polymériques.

les premières particules et/ou les deuxièmes particules étant ajoutées lors de l'une des étapes a1, b1) ou c1) ou après l'étape c1).

Avantageusement, l'agent chélatant est l'acide acétique ou l'acide butyrique. Un tel réactif se trouve facilement dans le commerce.

Avantageusement, l'agent complexant est l'éthanolamine ou l'éthylène glycol. Un tel réactif se trouve facilement dans le commerce.

Avantageusement, les sels métalliques sont des acétates métalliques et/ou des nitrates métalliques et /ou des chlorures métalliques. Ces sels métalliques sont disponibles dans le commerce et sont souvent moins chers que les alcoxydes métalliques, classiquement utilisés dans les procédés sol-gel. On choisira avantageusement des acétates métalliques. L'utilisation d'acétates métalliques, par rapport aux alcoxydes métalliques, permet d'avoir un plus grand choix d'élément métallique pour former la matrice sol-gel. L'utilisation d'acétate métallique permet à la fois de fournir le sel métallique et au moins une partie de l'agent chélatant. De plus, les acétates métalliques sont stables en présence d'eau, et peuvent être utilisés sans avoir besoin de travailler en boîte à gants, ce qui facilite le procédé de préparation.

L'invention concerne également un procédé de fabrication d'un capteur de motif thermique comprenant les étapes successive suivantes :

- fourniture d'un substrat,
- formation d'une première électrode,
- dépôt d'un matériau pyroélectrique sur la première électrode selon l'étape b) telle que précédemment décrite,

- formation d'une deuxième électrode,
- éventuellement formation d'une couche diélectrique et formation d'un élément chauffant,
- éventuellement formation d'une couche de protection.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente, de manière schématique, une vue en coupe d'un pixel d'un capteur de motif thermique, selon un mode de réalisation particulier de l'invention,
- la figure 2 représente de manière schématique, en coupe, une couche pyroélectrique d'un capteur de motif thermique, selon un mode de réalisation particulier de l'invention,
- la figure 3 représente de manière schématique, en coupe, une couche pyroélectrique d'un capteur de motif thermique, selon un autre mode de réalisation particulier de l'invention,
- la figure 4 représente de manière schématique, en coupe, une couche pyroélectrique d'un capteur de motif thermique, entourée par deux électrodes selon un mode de réalisation particulier de l'invention,
- la figure 5 représente schématiquement, en vue de dessus des lignes métalliques formant l'électrode inférieure et des lignes métalliques formant les éléments chauffants, selon un mode de réalisation particulier de l'invention,
- les figures 6A à 6D représentent des clichés, obtenus par microscopie électronique à balayage, de la surface d'un matériau pyroélectrique obtenu selon un mode de réalisation particulier de l'invention, pour différentes températures de recuit,
- la figure 7 représente le nombre de pores et le pourcentage surfacique de pores en fonction de la température de recuit d'un matériau pyroélectrique obtenu selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

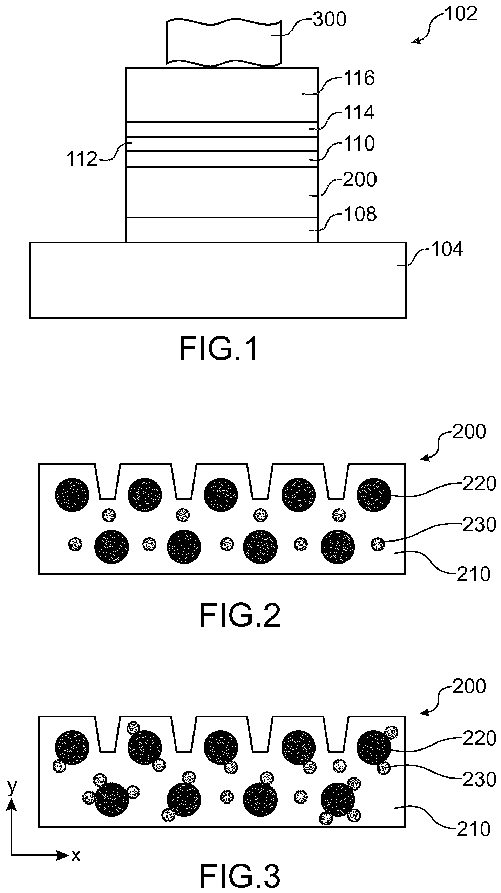

On se réfère tout d'abord à la figure 1 qui représente une vue en coupe d'une partie d'un pixel 102 d'un capteur de motif thermique.

## Le substrat 104 :

Le pixel 102 est réalisé sur un substrat 104 par exemple en verre ou en matériau semi-conducteur (par exemple du silicium).

Le substrat 104 peut également être un substrat souple, par exemple à base de polyimide ou de PEN (polyéthylène naphtalate) ou de PET (polyéthylène téréphtalate), sur lequel les éléments électroniques du capteur, tels que des transistors en couches minces (TFT pour « Thin Film Transistor »), sont réalisés par technologie électronique imprimée (par exemples via une réalisation avec des têtes d'écriture de type jet d'encre) ou par lithographie.

Des substrats en verre peuvent également être utilisés. Il s'agit, par exemple, de substrat de type « Eagle XG Slim Glass Substrates » commercialisé par la société de chez Corning.

## Les pixels 102 :

Un seul pixel est représenté sur le substrat 104 représenté à la figure 1, pour plus de lisibilité, mais le substrat d'un capteur de motif thermique comporte une pluralité de pixel 102. Les pixels 102 du capteur sont disposés en formant une matrice de plusieurs lignes et plusieurs colonnes de pixels 102. Le pas des pixels 102, dans le plan du substrat 104, est par exemple compris entre environ 50 $\mu$m et 100 $\mu$m. Dans le cas d'un capteur de résolution égale à 500 dpi (« dot per inch »), le pas des pixels 102 est égal à 50,8 $\mu$m.

Chacun des pixels 102 du capteur comporte des moyens de mesure, ou de détection, thermique formés par une capacité pyroélectrique. Chaque capacité pyroélectrique comporte un matériau pyroélectrique 200 disposé entre une électrode inférieure 108 et une électrode supérieure 110. La capacité peut être une capacité horizontale ou une capacité verticale.

Le matériau pyroélectrique 200 :

Comme représenté sur les figures 2, 3 et 4, le matériau pyroélectrique 200 est une couche mince sol-gel comprenant :

- des premières particules 220 en un premier matériau (matériau A) le premier matériau étant choisi parmi les oxydes de calcium, de lanthane, de tantale, de baryum, de plomb, et/ou de strontium,
- des deuxièmes particules 230 en un deuxième matériau (matériau B), le deuxième matériau étant choisi parmi les oxydes de titane, d'antimoine, d'étain, de zinc, de gallium, de vanadium et/ou de manganèse,
- une matrice sol-gel 210 en un troisième matériau (matériau C) à base d'oxyde d'aluminium, de silicium, de gallium et/ou de zirconium et, de préférence, poreuse.

La matrice sol-gel 210 est en un matériau différent des premières particules 220 et des deuxièmes particules 230. Les premier, deuxième et troisième matériaux sont différents.

La matrice sol-gel 210 est un matériau amorphe en oxyde métallique. Elle présente une faible permittivité diélectrique $\varepsilon r$ et, avantageusement, un très faible coefficient pyroélectrique. L'homme du métier choisira un oxyde métallique compatible et possédant une permittivité relative la plus basse possible, c'est-à-dire inférieure à 30, et de préférence inférieure ou égale à 15. De préférence, la matrice est en oxyde d'aluminium et/ou de d'oxyde de silicium et/ou d'oxyde de zirconium. Une matrice en $Al_2O_3$ présente une permittivité de l'ordre de 8-9, une matrice en $ZrO_2$ a une permittivité de 15. Une matrice en $SiO_2$ présente une permittivité de l'ordre de 4. A titre de comparaison, le PVDF a une permittivité de 10.

Le matériau pyroélectrique obtenu a un coefficient pyroélectrique allant de 30 à 80 $\mu C/(m^2K)$ voire de 40 à 100 $\mu C/(m^2K)$, c'est-à-dire entre un coefficient pyroélectrique compris entre celui du PVDF (de 20 à 35$\mu C/(m^2K)$) et celui des céramiques. Par exemple, $BaTiO_3$ a un coefficient pyroélectrique de l'ordre de 100 $\mu C/(m^2.K)$), mais une permittivité d'environ 1000, ce qui diminue fortement sa figure de mérite.

On choisira de préférence une matrice sol-gel poreuse. L'augmentation de la porosité diminue à la fois la permittivité diélectrique et la conductivité thermique, dans un plan parallèle à la surface du substrat (axe x sur la figure 3). De préférence, le matériau pyroélectrique a une porosité surfacique supérieure à 15% de la surface totale du matériau pyroélectrique.

L'homme du métier cherchera à avoir une quantité suffisante de matériau sol-gel dans le matériau pyroélectrique afin de diminuer la permittivité globale de la couche (de préférence de 30% à 70% massique, par exemple de l'ordre de 40% massique).

La matrice sol-gel 210 présente une ségrégation de premières particules 220 et/ou une ségrégation de deuxièmes particules 230. Par particules, on entend des éléments de taille micrométrique ou nanométrique et de forme sphérique, cylindrique, ou ovoïde.

Les premières particules 220 et les deuxièmes particules 230 permettent d'augmenter la conductivité thermique, perpendiculairement à la surface du substrat 104 (axe y sur la figure 3).

La porosité de la matrice sol-gel et la présence des premières particules 220 et deuxièmes particules 230 ont un effet synergique conduisant à une amélioration de la résolution de détection et de la sensibilité.

Les premières particules 220 sont en un élément ayant un grand rayon ionique (par exemple, un rayon ionique moyen supérieur à 130pm), sous forme oxydée. De préférence, la distance entre les premières particules 220 est faible (inférieure à 50 nm). Les premières particules 220 présentent de bonnes propriétés pyroélectriques. Les premières particules 220 ont un plus grande dimension allant de 50 à 100 nm, et de préférence, de 10 à 70 nm. De préférence, les premières particules 220 sont en oxyde de baryum, en oxyde de plomb et/ou en oxyde de strontium.

Les deuxièmes particules 230 sont en un élément ayant un rayon ionique moyen (par exemple, un rayon ionique moyen inférieur à 130pm), sous forme oxydée. Ces deuxièmes particules 230 améliorent le coefficient pyroélectrique de la couche en matériau sol-gel. Les deuxièmes particules 230 ont une plus grande dimension allant de 10 à 200 nm, et de préférence, de 20 à 50 nm. De préférence, les deuxièmes particules 230 sont en oxyde d'antimoine, en oxyde de vanadium, en oxyde de titane et/ou en oxyde de zinc. Par oxyde de vanadium, on entend $V_2O_5$, ou $VO_2$. L'oxyde $Sb_2O_3$ a une permittivité diélectrique d'environ 12, ce qui est particulièrement avantageux pour diminuer la permittivité du matériau pyroélectrique.

L'homme du métier choisira la taille et le nombre de premières particules 220 et/ou de deuxièmes particules 230 en fonction de la quantité de charges électriques désirées dans le matériau pyroélectrique 200.

La différence de rayon ionique entre les premières particules et les deuxièmes particules déstabilise l'équilibre électrique qui s'opère à l'échelle de la maille cristalline ou amorphe. La présence des premières particules 220 et des deuxièmes particules 230 conduit à la création de moment dipolaire au sein de la matrice sol-gel. Le matériau pyroélectrique obtenu présente une structure, de préférence, non centro-symétrique.

La matrice peut en outre contenir des résidus organiques diélectriques.

La matrice présente des domaines de chacun de ses éléments. On parle de matrice auto-organisée. A tire illustratif, la matrice auto-organisée peut contenir une matrice sol-gel 210 à base d'oxyde d'aluminium et/ou de d'oxyde de silicium et/ou d'oxyde de zirconium, des premières particules 220 en oxyde de Sr, en oxyde Pb et/ou en oxyde de Ba et des deuxièmes particules 230 en oxyde de Zn, et/ou d'oxyde de Ti et/ou d'oxyde de Va.

On choisira, de préférence, l'une des associations suivantes :

- une matrice sol-gel 210 en oxyde d'aluminium avec des premières particules 220 en oxydes de strontium et deuxièmes particules 230 en oxyde de zinc,
- une matrice sol-gel 210 en oxyde de silicium avec des premières particules 220 en oxyde de strontium et deuxièmes particules 230 en oxyde de zinc,
- une matrice sol-gel 210 en oxyde de silicium avec des premières particules 220 en oxyde de strontium et deuxièmes particules 230 en oxyde de vanadium,
- ou encore une matrice sol-gel 210 en oxyde d'aluminium avec des premières particules 220 en oxyde de strontium et deuxièmes particules 230 en oxyde de vanadium.

On pourra également choisir une matrice 210 en SiO$_2$, des premières particules 220 en oxyde de plomb et des deuxièmes particules 230 en oxyde de titane ou une matrice 210 en oxyde d'aluminium, des premières particules 220 en oxyde de strontium et des deuxièmes particules 230 en oxyde de titane.

De préférence, le matériau pyroélectrique comprend de 30% à 70% massique de matrice sol-gel 210, de 30% à 50% massique de premières particules 220, et de 10% à 20% massique de deuxièmes particules 230.

L'épaisseur du matériau pyroélectrique 200 va par exemple de 20 nm à 5 μm. De préférence, elle va de 10 nm à 3 μm, plus préférentiellement de 100 nm à 2 μm et, encore plus préférentiellement, elle est de 500 nm. L'épaisseur de matériau pyroélectrique 200 déposée est contrôlée car cette épaisseur correspond à l'épaisseur de la capacité pyroélectrique (distance entre les électrodes) et intervient directement dans le calcul de la valeur de la capacité pyroélectrique C utile pour extraire la permittivité. L'épaisseur n'est pas reliée au coefficient pyroélectrique.

Les électrodes 108, 110 :

L'électrode inférieure 108 et l'électrode supérieure 110 comportent chacune au moins un matériau électriquement conducteur. Les électrodes 108, 110 peuvent comporter au moins l'un des matériaux suivants : Ti, Pt, Ni, Au, Al, Mo, Ag, AlSi, AlCu, TiAu. L'une des électrodes 108, 110, avantageusement l'électrode supérieure 110, ou chacune des deux électrodes 108, 110, peut être formée par un empilement de plusieurs matériaux électriquement conducteurs, par exemple un empilement Ti/TiN ou Ti/TiN/AlCu, ou Ti/Au.

L'épaisseur de chacune des électrodes 108, 110 est par exemple comprise entre environ 0,01 μm et 1 μm. L'épaisseur de chacune des électrodes 108, 110 peut être plus importante, allant par exemple jusqu'à environ 5 μm, notamment lorsque ces électrodes sont réalisées par impression en utilisant des matériaux tels que l'argent, le cuivre, le carbone ou encore le PEDOT(poly(3,4-éthylènedioxythiophène).

A titre illustratif et non limitatif, l'électrode supérieure 110 et/ou l'électrode inférieure 108 est une couche d'épaisseur égale à environ 0,2 μm, en titane et/ou en molybdène et/ou en aluminium et/ou en un oxyde conducteur tel que de l'ITO (oxyde d'indium et d'étain) et/ou un polymère conducteur.

A titre illustratif et non limitatif, l'électrode supérieure 110 et/ou l'électrode inférieure 108 est formée d'un ou plusieurs empilements de type Ti/TiN avec une épaisseur de Ti comprise entre environ 50 nm et 500 nm et une épaisseur de TiN comprise entre environ 10 nm et 500 nm. On pourra également utiliser un empilement Ti/Au avec une épaisseur de Ti de 5 nm et une épaisseur de Au de 50 nm.

L'électrode supérieure 110 et/ou l'électrode inférieure 108 est, par exemple, sous la forme de lignes métalliques parallèles les unes aux autres. De telles lignes sont, par exemple, en or.

La couche diélectrique 112 :

L'électrode supérieure 110 est recouverte par une couche diélectrique 112. L'épaisseur de la couche diélectrique va par exemple de 0,1 μm à 5 μm. La couche diélectrique est, par exemple, en polyimide. Elle permet d'isoler électriquement l'électrode supérieure 110 des éléments chauffants 114.

Les éléments chauffants 114 :

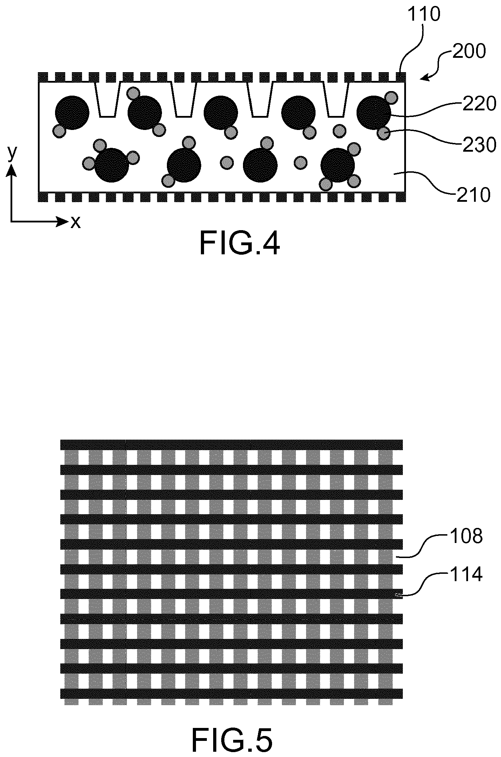

Dans le mode de réalisation où le capteur est apte à réaliser une détection thermique active, en plus des éléments précédemment décrits, le capteur comporte également des éléments chauffants 108 dissipant une certaine quantité de chaleur dans les pixels 102, et notamment dans le matériau pyroélectrique 200. Ces éléments chauffants 108 sont par exemple formés par des portions électriquement conductrices issues de la même couche que celle servant à la réalisation des électrodes supérieures 110 ou des électrodes inférieures 108. Le ou les matériaux servant à la réalisation de l'élément chauffant 114 peuvent être choisis parmi mes matériaux suivants : Ti, Pt, Ni, Au, Al, Ag, AlSi, AlCu. Les éléments chauffants 114 sont par exemple réalisés par un dépôt d'une encre métallique, comprenant par exemple de l'argent, déposée par impression. Les éléments chauffants 114 sont, par exemple, sous la forme de lignes métalliques parallèles les unes aux autres. Comme représenté sur la figure 5, les lignes formant les éléments chauffants peuvent être perpendiculaires aux lignes de l'électrode inférieure 108.

L'élément chauffant 114 peut comprendre une couche en Ti ayant une épaisseur allant d'environ 3 nm à 10 nm et une autre couche électriquement conductrice en AlSi ou en AlCu et ayant une épaisseur allant de 10 nm à 70 nm, par exemple de 10 nm à 50 nm. Dans une telle configuration, la couche d'AlSi ou d'AlCu protège la couche de titane contre l'oxydation. On pourra également choisir une couche en titane de 5 nm d'épaisseur et une couche en or de 50 nm d'épaisseur.

Les éléments chauffants 114 ont, par exemple, une épaisseur allant de 0,03 μm à 1 μm, et de préférence allant de 30 à 70 nm. L'homme du métier choisira un matériau avec une résistance telle qu'il est possible de le chauffer correctement à faible tension (typiquement inférieure à 10V).

Chacun des éléments chauffants 114 forme un élément métallique résistif (résistance électrique par exemple comprise entre environ 10 Ω et 100 Ω) associé à un pixel 102 et qui permet de chauffer ce pixel 102 indépendamment des éléments chauffants 114 associés aux autres pixels 102. Les éléments chauffants 114 permettent, lors d'une détection mise en oeuvre par le dispositif, de dissiper une certaine quantité de chaleur dans les pixels 102, et notamment dans le matériau pyroélectrique de la couche 113. Dans chaque pixel 102, le chauffage de la portion 200 de matériau pyroélectrique est obtenu en faisant circuler un courant dans l'élément chauffant 114 formant la résistance de chauffage de chacun des pixels 102.

Le chauffage du matériau pyroélectrique 200 est obtenu en faisant circuler un courant dans l'élément chauffant 114 formant la résistance de chauffage de chacun des pixels 102. Afin d'obtenir une bonne sensibilité à la détection, traduisant une forte différence de températures entre un pixel en contact avec une crête de l'empreinte et un pixel en contact avec une vallée de l'empreinte, les puissances électriques injectées dans l'élément chauffant peuvent aller de 0,5 mW/pixel à 5 mW/pixel dans le cas de pixels ayant des côtés de dimension égale à environ 50 $\mu$m (comme c'est le cas pour un capteur d'empreinte digitale standard de résolution égale à 500 dpi).

La couche de protection 116 :

Les éléments chauffants 114 ainsi que les parties de la couche diélectrique 112 sur lesquelles les éléments chauffants 114 ne sont pas présents sont, avantageusement, recouverts par une couche de protection 116, correspondant par exemple à une couche laminée de PET ou de tout autre matériau adapté à la réalisation de cette couche. D'autres matériaux sont aussi envisageables pour cette couche 116, comme par exemple du polyimide, du PVDF et/ou de ses copolymères, du PMMA, etc. Le ou les matériaux utilisés ainsi que l'épaisseur de la couche sont choisis pour obtenir un bon transfert de la chaleur depuis la face avant de la couche de protection 116 vers la capacité pyroélectrique. Ainsi, la couche de protection 116 est réalisée telle qu'elle ne soit ni trop thermiquement résistive (car la chaleur ne la traverserait pas), ni trop thermiquement conductrice (car la chaleur partirait dans ce cas sur les côtés, vers les autres pixels, provoquant de la diathermie au sein du capteur), ni trop épaisse (pour avoir un transfert de chaleur s'opérant depuis la face avant vers la capacité pyroélectrique), ni trop fine (l'épaisseur de la couche 116 doit tout de même être suffisante pour que son rôle de protection soit rempli). L'épaisseur de la couche de protection 116 peut aller de quelques microns (par exemple 5 $\mu$m) à environ 100 $\mu$m. L'épaisseur est par exemple de l'ordre de 10 $\mu$m. De manière alternative, la couche de protection 116 peut correspondre à une couche de DLC (« Diamond Like Carbon ») d'épaisseur inférieure à environ 1 $\mu$m.

La face supérieure de la couche de protection 116 correspond à la surface sur laquelle se trouve le motif thermique destiné à être détecté, par exemple un doigt dont l'empreinte est destinée à être détectée. La partie d'un doigt 300 avec les creux et les bosses de l'empreinte sont représentées sur la figure 1.

**Procédé de fabrication du matériau pyroélectrique :**

La couche de matériau pyroélectrique est obtenue par dépôt d'une solution sol-gel.

La solution sol-gel comprend des polymères précurseurs de la matrice sol-gel, un solvant, les premières particules en un premier matériau et les deuxièmes particules en un deuxième matériau.

Les polymères précurseurs sont obtenus par polymérisation de complexes métalliques, obtenus en mélangeant des sels métalliques, un agent chélatant et éventuellement un agent complexant.

Préférentiellement, la solution sol-gel peut être obtenue en réalisant les étapes suivantes :

a1) Préparation d'une solution comprenant des sels métalliques et un solvant, de préférence, un solvant organique, et encore plus préférentiellement un solvant organique polaire, et mélange de la solution jusqu'à dissolution des sels métalliques dans le solvant, de manière à obtenir des ions métalliques.
b1) Ajout d'un agent chélatant et, éventuellement, d'un agent complexant à la solution obtenue à l'étape a1), de manière à former un complexe métallique, à partir des ions métalliques et de l'agent chélatant.
c1) Mélange et agitation de la solution à une température supérieure à 50°C, par exemple à une température de 70°C, de manière à polymériser les complexes métalliques et à obtenir une solution sol-gel contenant les polymères précurseurs.

les premières particules et/ou les deuxièmes particules étant ajoutées lors de l'une des étapes a1, b1) ou c1) ou après l'étape c1).

Le solvant est, par exemple, le 2-isopropoxyethanol, le méthanol, le 2 méthoxyéthanol. De préférence, il s'agit du 2-isopropoxyethanol qui est un solvant « vert », non CMR (cancérigène mutagène reprotoxique). La nature chimique des polymères précurseurs peut influencer les distances entre les premières particules et/ou entre les deuxièmes particules.

De préférence, les sels métalliques sont choisis parmi les acétates métalliques et/ou les nitrates métalliques et/ou les chlorures métalliques.

L'utilisation de contre-ions de différentes natures permet d'augmenter le désordre au sein de la couche, i.e. la ségrégation des différents constituants.

Les nitrates métalliques favorisent la formation de liaison hydroxyde, mais ils sont difficile à éliminer à faible température. L'étape de recuit devra donc être réalisée à plus haute température.

Les chlorures ont des températures de décomposition élevée (de l'ordre de 500°C).

Avantageusement, on utilise des acétates métalliques car ils sont insensibles à la présence d'eau en solution et donc plus stables. Il n'y a pas besoin de mettre en oeuvre le procédé sous atmosphère inerte. Avantageusement, les acétates forment après décomposition partielle des oxydes électriquement stables. Leur utilisation permet de réaliser des couches de manière reproductible.

L'agent chélatant ajouté à l'étape b1) peut être de l'acide butyrique. De préférence, il s'agit de l'acide acétique. Il évite la précipitation des ions métalliques lors du procédé sol-gel, et augmente la durée de vie de la solution préparée pour la mise en oeuvre du procédé sol-gel.

La solution sol-gel peut également comprendre un agent complexant pour stabiliser et favoriser l'étape de polymérisation du procédé. Il peut s'agir d'éthylène glycol. De préférence, il s'agit de l'éthanolamine.

Plus particulièrement et à titre illustratif, et non limitatif, la solution sol-gel peut être préparée en réalisant les étapes suivantes :

- ajouter des acétates métalliques et/ou nitrates métalliques et/ou chlorures métalliques à du 2-méthoxyéthanol, sous agitation, à 50°C, jusqu'à obtenir leur dissolution,
- former un complexe métallique par ajout d'acide acétique et d'éthanolamine dans le solvant, à 70°C ; le pH est de 5, la réaction peut durer quelques heures ; on forme des ions acétates et des ions métalliques ;
- réaliser la polymérisation des complexes métalliques, sous agitation à 70°C ;
- ajout des premières et/ou deuxièmes particules à l'étape a1), b1), ou c1) ou après l'étape c1).

La solution est ensuite déposée par toute technique de dépôt classiquement utilisée pour les méthode sol-gel. Par exemple, la solution est déposée par dépôt à la tournette (ou « spin-coating »). Le dépôt conduit à la formation d'une couche sol-gel.

Les couches minces obtenues par voie liquide sont généralement complexes : le mode de mûrissement de la solution, le recuit et leur impact sur la composition, ainsi que la porosité vont jouer un rôle primordial sur la structure, la morphologie et la surface spécifique de ces couches ainsi que sur la distribution des particules. Ces paramètres morphologiques seront en étroite relation avec les performances électriques et/ou pyroélectriques.

Avantageusement, un traitement thermique est réalisée après dépôt et formation de la couche sol-gel. L'étape de recuit permet d'éliminer les résidus organiques provenant de la synthèse (par exemple les additifs et/ou le solvant), qui peuvent influencer les propriétés pyroélectriques et/ou la permittivité de la couche.

Le traitement thermique est réalisé à une température, de préférence, supérieure à 150°C, par exemple de 150°C à 200°C, ou de 150°C à 250°C, encore plus préférentiellement à une température allant de 400°C à 500°C, par exemple de l'ordre de 450°C. Des températures de 150°C à 200°C pourront, avantageusement, être utilisées pour des recuits sur des substrats en polymère.

L'étape de recuit permet en plus d'augmenter la porosité de la couche sol-gel. La formation des pores dans les matériaux obtenus par voie liquide se fait par superposition de trois mécanismes: la décomposition par sublimation des éléments issus de la solution (précurseurs, stabilisateur, ou additif, par exemple), l'évaporation du solvant et la création de bulles de gaz. La formation des pores débute par l'évaporation du solvant. Selon la température, le solvant peut s'évaporer de façon plus ou moins brutale changeant ainsi la forme et la taille des pores. La température de recuit influence les mouvements de matière pendant l'évaporation du solvant et la décomposition des précurseurs.

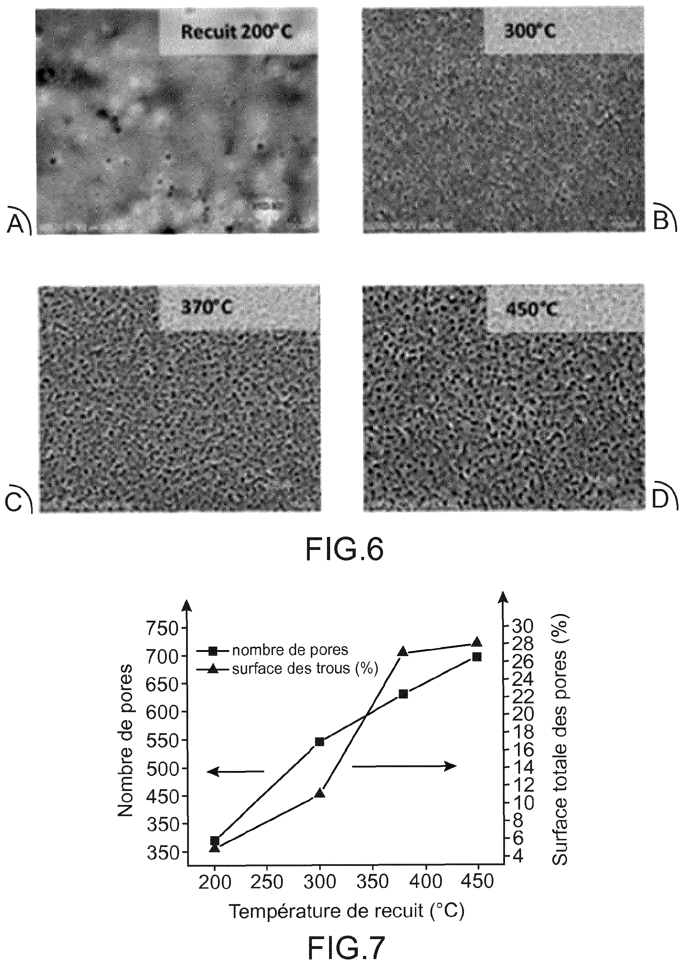

Le nombre de pores et leurs surfaces augmentent avec la température de recuit (figures 6A à 6D et figure 7). Les images ont été traitées avec le logiciel ImageJ.

Pour des températures allant de 200°C à 350°C, on observe un appauvrissement de la couche sol-gel en élément organique, puis les éléments métalliques se libèrent des éléments chélatants. La structure se déshydrate, le nombre de lacunes augmente.

Une température supérieure à 350°C permet d'avoir une porosité surfacique supérieure à 15% de la surface de la couche de matériau pyroélectrique déposée. Avantageusement, pour des températures supérieures à 350°C, on observe une démixtion des oxydes et un grossissement des premières particules 220 et des deuxièmes particules 230. La porosité peut également modifier la distribution des éléments dans la couche.

De manière encore plus avantageuse, on choisira une température supérieure à 400°C pour avoir une porosité supérieure à 25% de la surface. On diminue ainsi significativement la permittivité de la couche sol-gel.

La taille des pores, va par exemple 2 nm à 10 nm.

Le recuit peut être réalisé pendant une durée allant de quelques minutes (par exemple 5 minutes) à quelques heures (par exemple 2 heures). On peut, par exemple, réaliser un recuit à 150°C pendant 10 minutes.

Le recuit peut être réalisé dans un four.

Il peut également être réalisé par absorption de lumière intense (laser, xénon flash, infrarouge ou photonique), ce qui améliore la démixtion des différents oxydes.

Le recuit peut également être réalisé avec un rayonnement ultra-violet.

Il est également possible, en fonction de l'état cristallographique souhaité, de réaliser un recuit à une température allant jusqu'à 700°C, pendant par exemple 1h. On utilisera, par exemple, une étape de cristallisation soit par laser UV soit par recuit thermique à une température d'environ 650°C pour rendre le matériau pyroélectrique cristallin. Même si cela augmente sensiblement le coefficient pyroélectrique du matériau pyroélectrique, la permittivité diminue, car on favorise l'augmentation de la taille des particules et donc la démixtion, ce qui permet à la matrice d'être excédante.

**Procédé de fabrication du capteur de motif thermique :**

Un procédé de fabrication d'un capteur de motif thermique comprenant de telles capacités pyroélectriques va maintenant être décrit.

Le capteur est réalisé à partir du substrat 104. Le matériau du substrat 104 (verre, semi-conducteur, plastique, etc.) est choisi selon la technologie avec laquelle les différents éléments électroniques du capteur sont réalisés. On pourra, par exemple, utiliser un recuit alternatif de type recuit laser UV 248 nm sous une fluence de 50mJ/m$^2$ pour pouvoir intégrer des matériaux cristallins sur des substrats flexibles plastiques.

Le substrat 104 est tout d'abord nettoyé afin d'éliminer les résidus organiques présents sur celui-ci. Le type de nettoyage mis en oeuvre sera fonction du matériau du substrat 104.

La deuxième étape consiste à déposer sur la face avant du substrat 104 une première couche électriquement conductrice, par exemple métallique, à partir de laquelle l'électrode 108 est destinée à être réalisée. La couche peut être déposée en phase vapeur PVD par évaporation (« sputtering » en anglais), sérigraphie, pulvérisation (« spray » en anglais) ou même par jet d'encre, selon les matériaux et les épaisseurs destinés à être déposés. Lorsque la couche est formée par un dépôt PVD, l'épaisseur de la couche va, par exemple d'environ 100 nm à 2 $\mu$m. De manière générale, l'épaisseur de la couche est supérieure ou égale à environ 50 nm. D'autres types de dépôt peuvent permettre la réalisation d'une couche d'épaisseur supérieure à environ 2 $\mu$m. La structure des électrodes 108 peut être définie en mettant en oeuvre une étape de photolithographie et de gravure de la couche.

Le matériau pyroélectrique est ensuite formé sur la première électrode selon le procédé décrit ci-dessus.

Pour que le matériau pyroélectrique 200 acquière ses propriétés pyroélectriques, ce matériau est soumis, une fois pour toute la durée de vie de la capacité pyroélectrique, à un champ électrique d'environ entre 50 et 150 volts par micron d'épaisseur. Les molécules à l'intérieur de la couche pyroélectrique s'orientent, et restent orientées ainsi, même lorsque le matériau n'est plus soumis à ce champ électrique. Le matériau peut être ainsi polarisé en appliquant une tension de polarisation initiale aux bornes des électrodes 108, 110. On choisira, de préférence, une épaisseur de matériau pyroélectrique inférieure ou égale à environ 2 $\mu$m afin de favoriser la polarisation du matériau pyroélectrique de cette capacité, et le niveau de la tension électrique appliquée entre les électrodes 108, 110 pour réaliser la polarisation initiale de tout le matériau pyroélectrique (lorsque le matériau pyroélectrique doit être initialement polarisé).

Des portions du matériau pyroélectrique 200 sont ensuite définies par la mise en oeuvre d'une photolithographie et d'une gravure du matériau pyroélectrique.

Lorsque la gravure mise en oeuvre correspond à une gravure plasma, un plasma O$_2$ peut être utilisé seul ou en combinaison avec du SF$_6$ (hexafluorure de soufre). Les portions de matériau pyroélectrique conservées après la mise en oeuvre de cette gravure correspondent aux portions du matériau pyroélectrique localisées au niveau des pixels 102 du capteur.

En variante, les portions peuvent être réalisées directement, sans étape de gravure, par un dépôt localisé correspondant par exemple à un dépôt par spray à ultrasons, ou par jet d'encre ou par sérigraphie.

La seconde électrode, ou électrode supérieure, 110 est ensuite déposée, selon de techniques de dépôt qui peuvent être identiques ou différentes de celles utilisées pour déposer la première électrode.

Une ou plusieurs deuxièmes couches électriquement conductrices destinées à former les éléments chauffants 118 sont ensuite déposées sur la structure obtenue à ce stade du procédé. L'élément chauffant 118 est ensuite formé en gravant la ou les couches électriquement conductrices précédemment déposées selon le motif de l'élément chauffant 118, par exemple sous forme d'un serpentin ou sous la forme d'une ligne rectangulaire. Une étape de photolithographie suivie d'une étape gravure plasma ou en humide sont par exemple mises en oeuvre pour la formation de l'élément chauffant 118. La couche est gravée, par exemple via la mise en oeuvre d'une gravure plasma.

Le ou les matériaux destinés à former la couche de protection 116 est ou sont ensuite déposés sur l'ensemble de la structure précédemment réalisée. Selon le ou les matériaux déposés, le ou les dépôts peuvent se faire par voie physique (par exemple PVD) à faible température ou par voie liquide (par exemple par centrifugation, pulvérisation ou jet d'encre). Lorsque ce ou ces matériaux de protection sont déposés de manière localisée, comme par exemple par pulvérisation ou par jet d'encre, la couche de protection 116 est formée dès le dépôt de manière localisée sur l'élément chauffant 118 et les éventuelles parties de matériau pyroélectrique non recouvertes par l'élément chauffant 118 (comme c'est le cas lorsque l'élément chauffant 118 forme un serpentin localisé uniquement au-dessus des portions 200), et il n'est pas nécessaire de mettre en oeuvre une gravure du ou des matériaux déposés pour former la couche 116.

Dans le cas contraire, le ou les matériaux sont déposés également à côté des portions de matériau pyroélectrique, une gravure, par exemple par plasma, est ensuite mise en oeuvre afin de supprimer les parties du ou des matériaux déposés à côté des portions, permettant ainsi l'accès aux extrémités.

Dans les différents exemples décrits précédemment, le capteur est utilisé en tant que détecteur d'empreinte digitale. Toutefois, le capteur peut être utilisé pour réaliser une détection de motifs thermiques autres que des empreintes digitales, du fait que chaque pixel 102 du capteur lit la capacité calorifique placée au-dessus de lui et cela quelle que soit la nature du motif thermique.

Par exemple, le capteur peut également servir à la réalisation d'un imageur infrarouge non refroidi. Les pixels 102 du capteur sont dans ce cas intégrés sur un circuit intégré de type CCD ou CMOS collectant les charges électriques générées par le capteur. Un tel imageur comporte en outre une lentille infrarouge filtrant la lumière arrivant sur le capteur. Afin que le capteur puisse être soumis à une différence de températures (nécessaire compte tenu de la mesure réalisée par les capacités pyroélectriques), l'imageur comporte un dispositif permettant successivement de bloquer la lumière infrarouge arrivant sur le capteur puis de laisser passer cette lumière. Un tel dispositif peut correspondre à un « chopper », c'est-à-dire une roue munie d'un trou et tournant devant le capteur. Un élément absorbeur peut être ajouté sur le matériau pyroélectrique afin d'améliorer l'absorption du rayonnement infrarouge reçu.

**Revendications**

1. Capteur de motif thermique, tel qu'un capteur d'empreinte digitale, comportant plusieurs pixels (102) disposés sur un substrat (104), chaque pixel (102) comprenant une capacité pyroélectrique, la capacité pyroélectrique comprenant un matériau pyroélectrique (200) disposé entre deux électrodes électriquement conductrices (108,110),
**caractérisé en ce que** le matériau pyroélectrique (200) comprend une matrice sol-gel (210) en oxyde métallique dans laquelle sont dispersées des premières particules (220) en un premier matériau et des deuxièmes particules (230) en un deuxième matériau,
le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium, de vanadium et/ou de manganèse.

2. Capteur selon la revendication 1, **caractérisé en ce que** la matrice sol-gel (210) est en au moins un oxyde choisi parmi les oxydes d'aluminium, les oxydes de silicium, les oxydes de gallium et les oxydes de zirconium.

3. Capteur selon l'une des revendications 1 et 2, **caractérisé en ce que** le matériau pyroélectrique est choisi parmi les matériaux suivants :

   - une matrice sol-gel (210) en oxyde d'aluminium avec des premières particules (220) en oxydes de strontium et deuxièmes particules (230) en oxyde de zinc,
   - une matrice sol-gel (210) en oxyde de silicium avec des premières particules (220) en oxyde de strontium et deuxièmes particules (230) en oxyde de zinc,
   - une matrice sol-gel (210) en oxyde de silicium avec des premières particules (220) en oxyde de strontium et deuxièmes particules (230) en oxyde de vanadium,
   - une matrice sol-gel (210) en oxyde d'aluminium avec des premières particules (220) en oxyde de strontium et deuxièmes particules (230) en oxyde de vanadium,
   - une matrice sol-gel (210) en oxyde de silicium avec des premières particules (220) en oxyde de plomb et des deuxièmes particules (230) en oxyde de titane,
   - une matrice sol-gel (210) en oxyde d'aluminium, des premières particules (220) en oxyde de strontium et des deuxièmes particules (230) en oxyde de titane.

4. Capteur selon l'une quelconque des revendications précédentes, **caractérisé en ce que** la distance entre les premières particules (210) est inférieure à 50 nm.

5. Capteur selon l'une quelconque des revendications précédentes, **caractérisé en ce que** le matériau pyroélectrique (200) comprend de 30% à 70% massique de matrice sol-gel (210), de 30% à 50% massique de premières particules (220), et de 10% à 20% massique de deuxièmes particules (230).

6. Capteur selon la revendication précédente, **caractérisé en ce que** le matériau pyroélectrique (200) comprend 40% massique de matrice sol-gel (210), 40% massique de premières particules (220), et 20% massique de deuxièmes particules (230).

7. Capteur selon l'une quelconque des revendications précédentes, **caractérisé en ce que** le matériau pyroélectrique (200) a une porosité surfacique supérieure à 15% de la surface totale du matériau pyroélectrique.

8. Capteur selon l'une quelconque des revendications précédentes, **caractérisé en ce que** le matériau pyroélectrique (200) a une épaisseur allant de 20 nm à 3 $\mu$m.

9. Procédé de préparation d'un matériau pyroélectrique tel que défini dans l'une quelconque des revendications 1 à 8, comprenant les étapes successives suivantes :

   a) fourniture d'un substrat (104),
   b) dépôt, sur le substrat, d'une solution sol-gel comprenant des précurseurs polymériques de la matrice sol-gel (210), un solvant, des premières particules (220) en un premier matériau et des deuxièmes particules (230) en un deuxième matériau, et évaporation du solvant de manière à former un matériau pyroélectrique (200),

le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium et/ou de manganèse.

10. Procédé selon la revendication précédente, **caractérisé en ce que**, après l'étape b), un traitement thermique à une température d'au moins 150°C, par exemple de 150°C à 250°C, et de préférence d'au moins 400°C, par exemple de 400° à 500°C, est réalisé sur le matériau pyroélectrique (200).

11. Procédé selon l'une des revendications 9 et 10, **caractérisé en ce que** la solution sol-gel de l'étape b) est obtenue en réalisant les étapes suivantes :

a1) Préparation d'une solution comprenant des sels métalliques et un solvant, de préférence, un solvant organique, et mélange de la solution jusqu'à dissolution des sels métalliques dans le solvant, de manière à obtenir des ions métalliques.
b1) Ajout d'un agent chélatant et, éventuellement, d'un agent complexant à la solution obtenue à l'étape a1), de manière à former des complexes métalliques, à partir des ions métalliques et de l'agent chélatant.
c1) Mélange et agitation de la solution, de préférence, à une température supérieure à 50°C, de manière à polymériser les complexes métalliques et à obtenir une solution sol-gel contenant les précurseurs polymériques.

les premières particules et/ou les deuxièmes particules étant ajoutées lors de l'une des étapes a1, b1) ou c1) ou après l'étape c1).

12. Procédé selon la revendication 11, **caractérisé en ce que** l'agent chélatant est l'acide acétique ou l'acide butyrique.

13. Procédé selon l'une des revendications 11 et 12, **caractérisé en ce que** l'agent complexant est l'éthanolamine ou l'éthylène glycol.

14. Procédé selon l'une des revendications 11 à 13, **caractérisé en ce que** les sels métalliques sont des acétates métalliques et/ou des nitrates métalliques et/ou des chlorures métalliques.

15. Procédé de fabrication d'un capteur de motif thermique comprenant les étapes successive suivantes :

- fourniture d'un substrat (104),
- formation d'une première électrode (108),
- dépôt d'un matériau pyroélectrique (200) sur la première électrode (108) par une solution sol-gel comprenant des précurseurs polymériques de la matrice sol-gel (210), un solvant, des premières particules (220) en un premier matériau et des deuxièmes particules (230) en un deuxième matériau, et évaporation du solvant de manière à former un matériau pyroélectrique (200),

le premier matériau étant choisi parmi les oxydes de calcium, de lanthane, de tantale, de baryum, de plomb, et/ou de strontium,
le deuxième matériau étant choisi parmi les oxydes de titane, d'antimoine, d'étain, de zinc, de gallium et/ou de manganèse,

- formation d'une deuxième électrode (110),
- éventuellement formation d'une couche diélectrique (112) et formation d'un élément chauffant (114),
- éventuellement, formation d'une couche de protection (116).

300

102

116

114

112 110

200

108

104

## FIG.1

200

220

230

210

## FIG.2

200

220

230

210

y

x

## FIG.3

FIG.4

FIG.5

FIG.6

FIG.7

EP 3 492 891 A1

Europäisches Patentamt
European Patent Office
Office européen des brevets

**RAPPORT DE RECHERCHE EUROPEENNE**

Numéro de la demande

EP 18 20 9894

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 2 645 403 A2 (MITSUBISHI MATERIALS CORP [JP]) 2 octobre 2013 (2013-10-02) * alinéas [0045] - [0048] * ----- | 1-15 | INV. G01J5/04 G01J5/02 G01J5/06 |
| A | FR 3 044 409 A1 (COMMISSARIAT ENERGIE ATOMIQUE [FR]; SAFRAN [FR]) 2 juin 2017 (2017-06-02) * abrégé; figure 2 * ----- | 1,9,15 | G01J5/34 G01J5/00 H01L37/02 |
| A | US 2016/276569 A1 (ALIANE ABDELKADER [FR]) 22 septembre 2016 (2016-09-22) * alinéas [0047], [0048]; figure 1D * ----- | 1,9,15 | |
| A | A. K. BATRA ET AL: "Present Status of Polymer: Ceramic Composites for Pyroelectric Infrared Detectors", FERROELECTRICS, vol. 366, no. 1, 21 octobre 2008 (2008-10-21), pages 84-121, XP055514627, US ISSN: 0015-0193, DOI: 10.1080/00150190802363207 * le document en entier * ----- | 1,9,15 | |

DOMAINES TECHNIQUES RECHERCHES (IPC)

G01J
H02N
H01L

Le présent rapport a été établi pour toutes les revendications

| Lieu de la recherche | Date d'achèvement de la recherche | Examinateur |
|---|---|---|
| Munich | 15 avril 2019 | Schmidt, Charlotte |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

16

**ANNEXE AU RAPPORT DE RECHERCHE EUROPEENNE
RELATIF A LA DEMANDE DE BREVET EUROPEEN NO.**

EP 18 20 9894

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-04-2019

| Document brevet cité au rapport de recherche | | Date de publication | Membre(s) de la famille de brevet(s) | | Date de publication |
|---|---|---|---|---|---|
| EP 2645403 | A2 | 02-10-2013 | CN | 103357562 A | 23-10-2013 |
| | | | EP | 2645403 A2 | 02-10-2013 |
| | | | JP | 2013207155 A | 07-10-2013 |
| | | | TW | 201344724 A | 01-11-2013 |
| | | | US | 2013260051 A1 | 03-10-2013 |
| FR 3044409 | A1 | 02-06-2017 | FR | 3044409 A1 | 02-06-2017 |
| | | | WO | 2017093252 A1 | 08-06-2017 |
| US 2016276569 | A1 | 22-09-2016 | EP | 3069390 A1 | 21-09-2016 |
| | | | FR | 3013510 A1 | 22-05-2015 |
| | | | US | 2016276569 A1 | 22-09-2016 |
| | | | WO | 2015071567 A1 | 21-05-2015 |

EPO FORM P0460

Pour tout renseignement concernant cette annexe : voir Journal Officiel de l'Office européen des brevets, No.12/82

**EP 3 492 891 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4394773 A
- US 4429413 A
- US 6289114 B
- EP 2385486 A1